# FASCICULE DE BREVET EUROPEEN

(11) **EP 2 073 260 B1**
(45) Date de publication et mention de la délivrance du brevet: **05.09.2012**
(21) Numéro de dépôt: 08171616.9
(22) Date de dépôt: 15.12.2008
(51) Int. Cl.: H01L 21/762, H01L 21/3105

(54) **Procédé de transfer d'une couche mince**
Übertragungsverfahren einer Dünnschicht
Thin film transfer method

(30) Priorité: 17.12.2007 FR 0759893
(43) Date de publication de la demande: 24.06.2009
(73) Titulaire: Commissariat à l'Énergie Atomique et aux Énergies Alternatives, 75015 Paris (FR)
(72) Inventeur: Di Cioccio, Léa, 38330, Saint Ismier (FR)
(74) Mandataire: Ilgart, Jean-Christophe

(56) Documents cités:
- FR-A- 2 895 562
- US-A1- 2003 108 715
- US-A1- 2004 009 649
- US-A1- 2006 240 275

## Description

### DOMAINE TECHNIQUE ET ART ANTERIEUR

L'invention concerne le domaine des couches minces, en particulier dans le domaine des matériaux semi-conducteurs.

Elle concerne en particulier une technique de report d'une couche mince sur un substrat hôte facilement démontable mais avec une énergie de collage satisfaisante entre la couche mince et le substrat.

Un procédé de fracture, connu sous le nom de Smart Cut^{™} est décrit dans l'article de A.J. Auberton-Hervé et al. « Why can Smart-Cut change the future of microelectronics ? » paru dans International Journal of High Speed Electronics and Systems, Vol. 10, N°.1 (2000), p. 131-146.

Ce procédé est notamment utilisé dans la réalisation de composants ou éléments de type SOI (abréviation de Silicon on Insulator, ou Silicium sur Isolant).

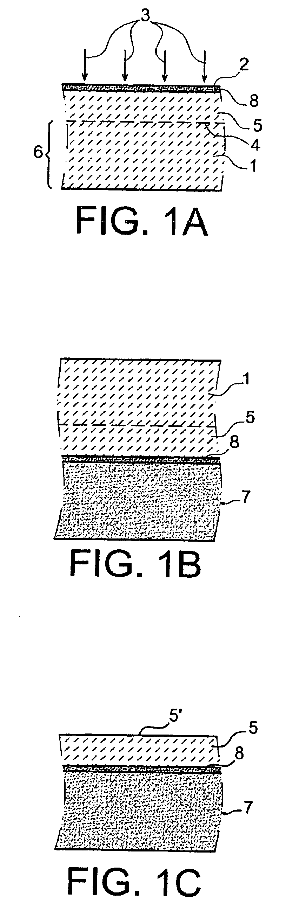

Une structure SOI comporte (figure 1C) en empilement un substrat support 7 (par exemple en silicium), une couche enterrée 8 de diélectrique, par exemple d'oxyde de silicium ou encore de nitrure tel que Si3N4 et une couche de silicium 5, dans laquelle peuvent se trouver des composants.

La couche enterrée 8 constitue une isolation vis-à-vis de courants parasites et de charges provenant de particules ionisées. Elle permet aussi une bonne isolation de composants voisins réalisés dans la même couche de silicium, et notamment une diminution sensible des capacités parasites entre de tels composants voisins, ainsi qu'une isolation de la couche mince 5 en matériau semi-conducteur par rapport au support 7 sous-jacent.

Les figures 1A à 1C illustrent un exemple de mise en oeuvre d'un procédé de transfert de couche selon le procédé Smart Cut^{™}, en vue de réaliser une structure SOI. Ces figures sont des vues en coupe transversale.

La figure 1A montre un substrat en silicium 1, muni d'une couche d'oxyde 8 en surface, au cours d'une étape d'implantation ionique ou atomique 3 d'une ou plusieurs espèces gazeuses à travers la face 2 de ce substrat. Il se forme alors une couche enterrée 4 constituant une zone fragilisée, qui sépare le substrat 1 en deux parties : une couche mince 5, située entre la face implantée 2 et la zone fragilisée 4, et la partie restante 6 du substrat située sous la zone fragilisée 4.

La figure 1B illustre une étape de solidarisation de la couche 5 du substrat 1, par sa face 2, sur un substrat support 7 ou raidisseur. Cette solidarisation peut être obtenue par collage direct (encore appelé collage moléculaire).

La figure 1C est le résultat d'une étape de séparation, induite par effet thermique et/ou mécanique, de la couche mince 5 et de la partie restante 6 (non représentée) du substrat 1, le long de la zone fragilisée 4. On peut ainsi obtenir une structure du type silicium sur isolant (structure SOI). En variante, cette structure pourrait être obtenue par collage moléculaire d'un substrat de silicium (éventuellement oxydé en surface) et d'un substrat hôte (également éventuellement recouvert d'une couche d'oxyde en surface) et amincissement mécano-chimique du substrat de silicium.

Ces techniques ne sont pas limitées à la production d'un substrat silicium sur isolant, mais peuvent être appliquées, plus généralement, à la production d'une structure « semi-conducteur sur isolant ». Sont notamment concernés, outre le silicium, le germanium, le nitrure de gallium, le carbure de silicium, l'arsénure de gallium, le phosphate d'indium...

Le substrat 7 permet de maintenir les deux précédentes couches minces 5, 8 empilées pour créer la structure finale. Il doit être suffisamment rigide pour favoriser la fracture dans le cas du procédé Smart Cut, dans la zone 4 d'implantation du substrat 1, plutôt que l'apparition de cloques en surface de la structure. De même, le collage entre les deux substrats (1,7) doit être suffisamment fort pour éviter tout décollement au niveau de cette interface de collage, notamment lors de l'application du traitement thermique de fracture dans le cas du procédé Smart Cut ainsi que pour permettre la réalisation de l'amincissement mécano-chimique.

Dans la plupart des cas, le collage du film détaché 5 sur son nouveau support 7 est définitif. C'est notamment le cas du SOI réalisé par les techniques précédemment décrites.

Mais, dans certains cas, on souhaite réaliser un double transfert de la couche 5. Par exemple, on peut souhaiter que la surface libre 5' de la couche mince 5 forme une surface enterrée après double report. Autrement dit, le transfert décrit ci-dessus en liaison avec les figures 1A - 1C est alors temporaire, et on réalise une étape supplémentaire de report, la face 5' de la couche 5 étant fixée sur un autre substrat et le substrat 7 étant éliminé.

C'est le cas, en particulier, pour les matériaux polaires, comme par exemple le SiC ou le GaN. Quand on veut rapporter un film mince 5 de ce matériau sur un deuxième support, on a besoin à nouveau de séparer ce film mince du premier substrat 7 de report (ou support temporaire) après l'avoir collé sur un nouveau substrat par sa face libre 5', ou avant de le coller sur ce nouveau substrat.

Pour séparer facilement le substrat 7, il serait intéressant de disposer entre ce substrat et la couche mince 5 d'une énergie de collage faible. Mais une telle énergie n'est pas toujours compatible avec le procédé d'amincissement utilisé pour obtenir le film mince comme décrit précédemment. Un double report ne peut se faire, non plus, en utilisant des supports souples car :
- soit ils sont trop mous et se déforment au cours du procédé d'amincissement,
- soit ils sont thermodéformables ou thermodégradables et ne supportent pas les températures imposées par le procédé de fracture sans se ramollir ou se dégrader, et ils ne gardent donc plus la rigidité nécessaire au procédé.

En outre on ne peut pas rigidifier de tels matériaux souples à l'aide d'un oxyde qui y serait déposé, car les différences de coefficients de dilatation entre ce matériau et l'oxyde déposé sont telles que ce dernier est contraint et que des ondulations apparaissent à la surface dudit matériau, ce qui produit une augmentation de la rugosité et empêche le collage.

US2006/240275 décrit un procédé de transfert d'une couche mince à partir d'un substrat initial par adhésion de ce substrat initial avec une face d'une couche de polymère de type silicone et amincissement du substrat initial, pour former la couche mince sur la couche de polymère de type silicone.

Le problème qui se pose donc est de trouver un substrat hôte qui soit suffisamment rigide pour permettre l'obtention d'une couche mince par amincissement (mécano-chimique ou par Smart Cut) d'un substrat de départ et qui puisse être facilement démonté.

### EXPOSE DE L'INVENTION

L'invention concerne un procédé de collage d'un substrat destiné à être aminci, sur un support temporaire, facilement démontable, mais permettant la réalisation du procédé d'amincissement en question.

Un report sur un substrat hôte ou temporaire est obtenu en collant un substrat de départ sur le substrat hôte puis en amincissant le substrat de départ pour obtenir la couche mince souhaitée. L'amincissement peut être un amincissement mécano-chimique ou peut résulter d'un procédé de fracture, tel celui connu sous le nom de Smart Cut^{™}.

L'invention concerne un procédé de transfert d'une couche mince, à partir d'un substrat initial, par exemple en matériau semi-conducteur, comportant les étapes suivantes :
a) assemblage par collage direct du substrat initial avec une face d'une couche de polymère de type silicone, cette face ayant subi un traitement sous rayonnement ultra-violet,
b) amincissement du substrat initial pour former la couche mince.

L'invention permet après le traitement sous UV du polymère, la création en surface du polymère d'un oxyde sur une forte épaisseur, comprise par exemple entre 10 µm et 20 µm. Cet oxyde assure après collage direct un assemblage fort et rigide entre le polymère et le substrat initial, compatible avec l'étape d'amincissement de ce substrat que ce soit par technique de fracture de substrat, de type Smart Cut^{™}, (sans mettre en oeuvre des températures allant au-delà de la température de stabilité du polymère) ou par amincissement mécanique et/ou chimique. Simultanément, cet oxyde confère au polymère une rigidité suffisante pour la réalisation de cet amincissement.

L'amincissement peut être réalisé par polissage mécanique et/ou chimique.

En variante, il peut être réalisé par la création, dans le substrat initial, avant l'étape d'assemblage a), d'une zone fragile enterrée, par implantation d'espèces ioniques et/ou atomiques, délimitant, dans ce substrat initial la couche mince à transférer, et l'application, après l'étape d'assemblage a), d'un traitement thermique et/ou mécanique de fracture du substrat initial, le long de la zone fragile enterrée

Avantageusement, la couche mince est transférée sur un autre substrat, dit de transfert.

L'invention concerne donc notamment un procédé de transfert d'une couche mince à partir d'un substrat initial, par exemple en matériau semi-conducteur, sur un substrat de transfert, par exemple un substrat final, ce procédé comportant les étapes suivantes:
a) création, dans le substrat initial, d'une zone fragile enterrée, par implantation d'espèces ioniques et/ou atomiques, délimitant, dans ce substrat la couche mince à transférer,
b) assemblage de ce substrat initial avec une face d'une couche de polymère de type silicone, cette face ayant subi un traitement sous rayonnement ultra-violet,
c) fracture du substrat initial, le long de la zone fragile enterrée, pour laisser la couche à transférer sur la couche de polymère de type silicone,
d) transfert de la couche sur le substrat de transfert.

L'invention concerne également un procédé de réalisation d'un transfert d'une couche mince d'un premier substrat vers un deuxième substrat, dit encore substrat de transfert, comportant :
- un premier transfert de ladite couche sur un substrat temporaire en matériau silicone traité en surface par un rayonnement UV,
- un deuxième transfert de ladite couche, du substrat temporaire en matériau silicone vers le deuxième substrat,
- une étape de pelage du substrat temporaire.

Le premier transfert peut avoir lieu par assemblage par collage direct, du premier substrat avec la face du substrat temporaire traitée sous UV. Un amincissement peut ensuite avoir lieu, par polissage mécanique et/ou chimique. En variante, il peut être réalisé par la création, dans le premier substrat, d'une zone fragile enterrée, par implantation d'espèces ioniques et/ou atomiques, délimitant, dans ce substrat la couche mince à transférer, et application d'un traitement thermique et/ou mécanique de fracture du premier substrat, le long de la zone fragile enterrée.

Selon l'invention, quel que soit le mode de réalisation, on utilise, en tant que substrat support ou temporaire, un polymère ayant subi un traitement sous rayonnement ultra-violet, qui présente les avantages déjà expliqués ci-dessus (en particulier formation d'un oxyde de forte épaisseur, qui assure ensuite un assemblage fort et rigide).

Sur ce substrat support ou temporaire, on effectue un collage temporaire, que l'on peut ensuite aisément décoller.

Quel que soit le mode de réalisation envisagé, le substrat de transfert, ou le deuxième substrat, peut être en un matériau rigide, ou en un matériau présentant une élasticité, par exemple en matériau silicone non traité sous UV.

Après transfert sur le substrat de transfert, ou sur le deuxième substrat, une étape de pelage de tout ou partie de la couche de polymère de type silicone peut être réalisée.

L'étape de pelage de la couche de polymère peut induire une séparation à l'interface entre le silicone et le silicone transformé en oxyde, ou dans la couche de silicone. Dans ce dernier cas, une étape d'élimination chimique du polymère résiduel pourra être prévue.

Une étape supplémentaire d'élimination de la partie de polymère transformé en oxyde peut être réalisée.

Avantageusement, le traitement sous rayonnement ultra-violet de la couche de polymère ou de silicone est réalisé sous atmosphère d'ozone.

À titre d'exemple, le silicone est du PDMS polymérisé.

Des traitements thermiques, et notamment à basse température, ou à température inférieure à la température de décomposition du silicone, peuvent être mis en oeuvre. En particulier, une étape de fracture le long d'un plan de fragilisation ou dans une zone de fragilisation, peut être réalisée par effet thermique, à une température inférieure à la température de décomposition du silicone.

Eventuellement, un traitement mécanique comporte par exemple l'insertion d'une lame, ou une courbure pour mise sous contrainte. Ceci contribue à la séparation, d'une part, du film mince collé sur le silicone, et, d'autre part, du substrat initial restant.

Avant l'étape d'assemblage, un recuit préliminaire de fragilisation peut être réalisé afin de limiter le budget thermique et/ou mécanique nécessaire pour l'obtention de la fracture après l'assemblage.

Préalablement à l'étape d'assemblage, et éventuellement avant l'étape implantation, une étape de dépôt d'une couche d'oxyde ou d'une couche de nitrure sur le substrat initial peut être réalisée.

Le matériau de la couche à reporter peut être semi-conducteur, par exemple du Si ou du Germanium ou du SiC ou du GaN.

### BRÈVE DESCRIPTION DES DESSINS

- Les figures 1A à 1C représentent un procédé de report d'une couche,
- les figures 2A à 2F illustrent un exemple de procédé selon l'invention,
- la figure 3 représente la structure chimique du PDMS, un polymère de type silicone pouvant être utilisé dans le cadre de l'invention.

### EXPOSÉ DÉTAILLÉ DE MODES DE RÉALISATION PARTICULIERS

L'invention va être décrite dans le cas d'un substrat ou d'une couche en polydimethylsiloxane (PDMS). Mais elle est réalisable avec tout polymère de type silicone, ces polymères présentant une chaîne à base de Si - O - Si - O, étant capable de se transformer en oxyde sous l'effet d'un rayonnement UV.

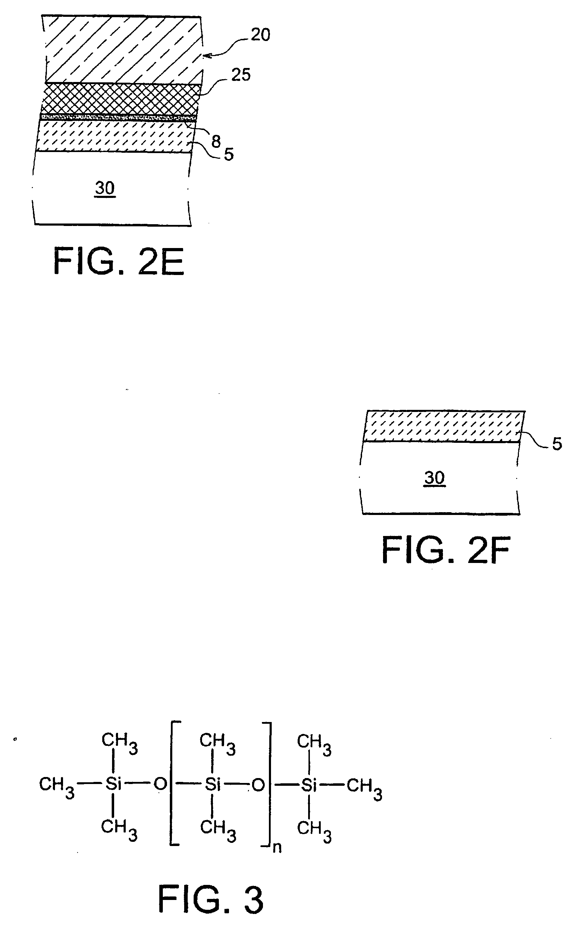

La figure 3 représente la formule chimique du PDMS. Celui-ci polymérise par polyaddition, c'est-à-dire par réaction en chaîne avec réunion de monomère, la réaction ayant lieu à l'aide d'un agent de réticulation. La réaction entre le polymère et l'agent de réticulation se fait sous l'action d'un catalyseur (contenue dans l'agent de réticulation) et de la chaleur ou du temps de séchage, suivant le schéma suivant :

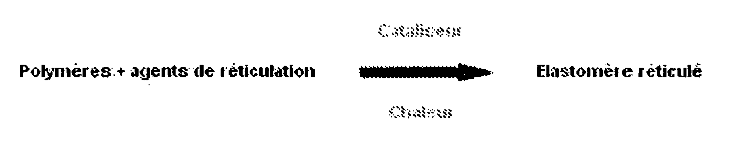

Ce mode de polymérisation n'engendre pas de dérivés (eau, dégagement gazeux etc...), ce qui rend le polymère compatible avec la microélectronique. Le catalyseur est désinhibé sous l'action de la température. Ainsi le PDMS peut être polymérisé à différentes températures allant de la température ambiante jusqu'à 150°C. Le temps de polymérisation est d'autant plus long que la température est plus basse. A titre d'exemple, à 150°C, le temps de polymérisation est de 15 min alors qu'à la température ambiante, il est de 7 jours. Le PDMS peut être déposé à la surface d'un matériau en couche de plusieurs millimètres d'épaisseur et est donc facilement manipulable.

La présence de liaisons covalentes entre le silicium et l'oxygène confère aux silicones une température de décomposition élevée, comparativement aux autres polymères. Ainsi, le PDMS reste stable entre -50°C et 250°C.

Après polymérisation, le PDMS est naturellement hydrophobe (on peut mesurer un angle de contact θ supérieur à 90°) du fait de ses terminaisons CH₃.

Or, pour effectuer un collage hydrophile, ce qui est souhaité dans le cas du report de couche envisagé, on cherche à ce que les deux surfaces à coller présentent des terminaisons (OH).

Le PDMS offre la particularité de devenir hydrophile, en surface, sous l'influence de différents traitements, tels qu'un traitement plasma ou un traitement par UV/Ozone.

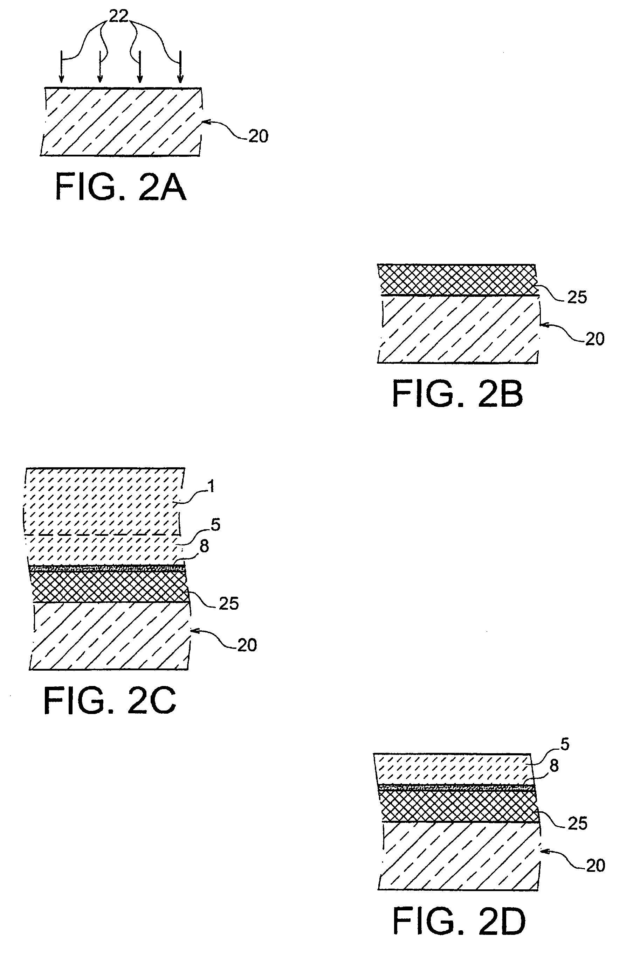

La figure 2A représente un substrat 20 réalisé en ce matériau polymère PDMS. Ce substrat est soumis à un traitement 22 sous UV (par exemple sous atmosphère Ozone), qui permet justement de changer les propriétés hydrophobes du PDMS en propriétés hydrophiles. Sous l'effet du rayonnement UV, le silicone réagit pour former des radicaux libres et pour former des liaisons SiOₓ comme illustré ci-dessous:

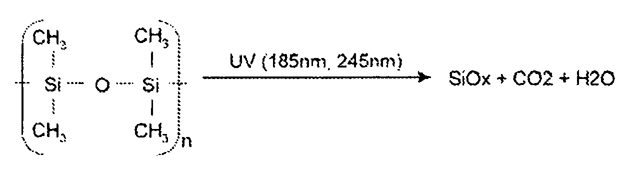

Il se forme donc un film 25 d'oxyde, en surface du substrat 20 (figure 2B). L'épaisseur de ce film 25 en SiOₓ peut atteindre 10 µm voire 20 µm en fonction du temps d'exposition. Cette couche ou ce film 25 est rigide, tandis que le matériau sous jacent à cette couche garde les propriétés de souplesse du polymère initial.

On notera que cette couche ou ce film 25 résulte d'une transformation du polymère, et non de la réalisation d'un dépôt sur le polymère. On évite ainsi tous les problèmes liés à la différence entre les coefficients de dilatation thermique du polymère et d'une couche d'oxyde, lorsque cette dernière est simplement déposée sur le polymère.

Comme indiqué ci-dessus, d'autres traitements du polymère peuvent être réalisés pour obtenir une couche 25 hydrophile. C'est le cas d'un traitement par plasma oxygène. Un tel traitement plasma permet, en effet, l'apparition de groupes Si-OH qui se substituent aux groupes Si-CH3 à la surface du PDMS. Cette modification de la structure du PDMS intervient sur une épaisseur pouvant atteindre 130 à 160 nm et lui confère un caractère particulièrement hydrophile (angle de contact inférieur à 3°). En outre, pour un traitement réalisé au plasma oxygène, la réaction est plus rapide que sous UV (20s pour atteindre un angle de 3° sous plasma contre 60min dans le cas d'un traitement sous UV) Mais, ce traitement plasma n'est pas définitif et le caractère hydrophile de la surface s'estompe après 45min. Le traitement sous UV offre donc l'avantage de rendre la surface hydrophile de manière plus définitive que le traitement réalisé au plasma oxygène. Enfin, une analyse AFM de la surface du polymère après un traitement plasma montre la présence d'ondulations, qui confèrent à cette surface une rugosité ne permettant pas un collage hydrophile.

Contrairement au traitement plasma, une exposition aux UV permet une transformation plus durable qu'un traitement plasma, ne crée pas ces ondulations en surface, et ne provoque donc aucune rugosité.

Une mesure effectuée sur la surface d'un substrat 25 en PDMS montre d'ailleurs que sa rugosité :
1) est de 17,8 nm après traitement plasma,
2) alors qu'elle reste de 0.57nm après traitement sous UV, donc équivalente à la rugosité après polymérisation.

Un collage peut ensuite être réalisé sur le substrat 25 de polymère ayant subi le traitement sous UV mentionné ci-dessus.

Comme indiqué ci-dessus, la portion superficielle 25 du substrat 20 est rigide. Par le traitement réalisé, on obtient donc un rigidificateur - la couche d'oxyde - à la surface du polymère, ce qui est favorable pour un procédé ultérieur d'amincissement, par exemple pour la réalisation d'un procédé de type Smart Cut^{™}.

Il faut néanmoins souligner que le substrat 20 en PDMS garde une certaine élasticité, du fait de sa partie non oxydée.

Par ailleurs, un substrat 1 peut être implanté ou avoir été implanté comme expliqué ci-dessus en liaison avec la figure 1A. Il s'agit par exemple d'un substrat semi-conducteur de Silicium ou de Germanium ou de GAN, ou de SIC ou encore de LTO (LiTa03). Un tel substrat est par exemple implanté avec un faisceau d'hydrogène, à des doses comprises entre 5 10 ¹⁶ at/cm³ et quelques 10¹⁷ at/cm³ par exemple 5. 10¹⁷ at/cm³ ou 10¹⁸ at/cm³, et ce avec une énergie de l'ordre de 50 keV à 200 keV, par exemple comprise entre 70 keV à 180 keV.

Avantageusement, préalablement à l'implantation on aura déposé une couche mince 8 d'oxyde (ou de nitrure, par exemple du SiON) de quelques nm, par exemple 5 nm, à 1µm environ. Cet oxyde permettra soit d'effectuer un polissage si la rugosité de surface du semi-conducteur 1 est forte soit de préparer la surface au collage par des préparations telles que le traitement plasma ou le polissage mécanochimique ou un traitement humide, ces traitements ayant pour but de laisser la surface hydrophile.

Un traitement thermique de fragilisation est possible à ce stade, le budget thermique de cette étape n'induisant pas de cloque en surface du substrat, ce qui empêcherait tout collage ultérieur.

La surface du substrat en PDMS 20, traité comme expliqué ci-dessus, et la surface 2 d'un substrat semi-conducteur implanté 1 du type de la figure 1A (éventuellement muni d'une couche 8 comme expliqué ci-dessus) peuvent ensuite être mises en contact (figure 2C). Le collage est de type collage direct ou par adhésion moléculaire, technique de collage qui est décrite notamment par Q.Y. Tong dans « Silicon Wafer Bonding Technology for VLSI and MEMS applications », Edited by S.S.Iyer and A.J. Auberton - Hervé, 2002, INSPEC, London, Chapter 1, pages 1-20.

Un recuit de solidarisation du collage peut éventuellement alors être réalisé, par exemple entre 100°C et 200°C. La durée de ce recuit est comprise entre quelques minutes et quelques heures. Ce recuit est effectué avec un budget thermique, donc à une température et pendant une durée, tels qu'il ne provoquera pas les conditions de bullage et ou de clivage dans le semi-conducteur 1.

On effectue ensuite le recuit de fracture entre 200°C et 250°C par exemple, assisté ou non d'un traitement mécanique (insertion de lame, et/ou courbure du semi-conducteur 1 pour mise sous contrainte...). Dans cette gamme de température, le PDMS reste stable. On a alors une fine couche 5 de semi-conducteur à la surface du substrat 20 en PDMS (figure 2D).

En variante, la couche mince 5 peut être obtenue non pas par implantation/fracture comme décrit ci-dessus mais par une étape d'amincissement mécano-chimique du substrat 1 non implanté, une fois assemblé avec la couche de polymère durcie en surface.

Quel que soit son mode d'obtention, la couche 5 peut être ensuite reportée et collée sur un support 30 (figure 2E), par collage moléculaire, de type hydrophile ou hydrophobe. Ce support 30 peut être un support final.

On peut ensuite procéder à un pelage du substrat 20 de polymère (figure 2F). C'est la grande élasticité du substrat 20 en PDMS - que celui-ci a conservé dans sa partie non transformée en oxyde - qui va permettre cette opération de retrait par pelage. Ce pelage est d'autant plus aisé que l'épaisseur du substrat 20 est importante. Par exemple, une épaisseur de quelques mm, par exemple comprise entre 1 mm et 3mm ou 3 mm, permet un retrait manuel.

Lors de cette opération de retrait par pelage, la rupture peut se faire à l'interface entre le polymère non transformé et le polymère transformé en oxyde, il s'agit alors d'une rupture adhésive.

Ou bien, cette rupture se fait au sein même du polymère 20, dans sa partie non transformée, il s'agit alors d'une rupture cohésive. Dans ce cas, le reste de la couche 20 de polymère non transformé peut ensuite être retiré chimiquement, par exemple à l'aide d'une solution de Tetra-n-butylammonium fluoride, 1M solution dans le Tetrahydrofuran (TBAF). Cette solution permet de dissoudre le PDMS. La vitesse de gravure de cette solution est estimée à 3 µm/min.

La couche 25 de polymère transformé en oxyde pourra également être à son tour éliminée, par exemple par un traitement HF ou une gravure sélective.

Le substrat 30 peut lui-même présenter une certaine rigidité. Dans ce cas, ce substrat peut être un substrat final.

En variante, ce substrat 30 peut aussi offrir une certaine souplesse, par exemple pour permettre une relaxation des contraintes dans la couche ou le film 5 reporté ; dans ce cas, il ne s'agit pas d'un substrat final. Il peut en particulier s'agir d'un substrat en silicone, par exemple lui aussi en PDMS, mais non traité sous UV.

Dans un exemple de réalisation, le PDMS utilisé est le Sylgard 184 de Down Corning. Il est composé d'un monomère et d'un amorceur thermique.

L'amorceur est mélangé dans la proportion de 1:10. Le mélange engendre des bulles d'air qui sont retirées en plaçant le mélange sous vide (10⁻¹ bar). Le polymère peut alors être conditionné durant 2h avant le début de polymérisation. Celui-ci est versé dans des moules et polymérisé à température ambiante afin d'éviter les contraintes qui pourraient intervenir lors du refroidissement après une polymérisation en température, du fait de son fort coefficient de dilatation thermique.

On obtient alors un support 20 en PDMS dont l'épaisseur est comprise entre quelques µm et quelques mm, par exemple comprise entre, d'une part, 1 µm ou 5 µm ou 10 µm et, d'autre part, 1 mm ou 5 mm ou 10 mm. On peut laisser ce support collé sur la plaque qui a servi de moule ou le désolidariser de cette plaque.

Le support en PDMS est alors traité sous UV (avantageusement sous atmosphère ambiante, le rayonnement UV transformant alors l'oxygène de l'air en ozone : on parle dans ce cas de traitement UV/Ozone). On transforme ainsi en oxyde la surface du substrat 20 en PDMS, sur une épaisseur comprise entre 1 µm et 15 µm, pour une durée de traitement comprise entre 20 mn ou 30 mn et 120 minutes. On a alors un support en PDMS rigidifié en surface par une transformation qui conduit à une épaisseur d'oxyde importante.

De son côté, le substrat semi-conducteur 1, dont on veut reporter une couche mince 5 (figure 1A), est implanté avec les espèces gazeuses 3 qui permettent la réalisation du procédé « Smart Cut^{™ »}, telles que l'hydrogène et/ou l'hélium.

Des exemples d'implantation, leurs énergies et leurs doses ont déjà été données ci-dessus.

Avantageusement, on choisit des conditions d'implantation qui permettent un clivage à une température en dessous de 250°C, température de décomposition du PDMS comme par exemple cela peut se faire en réalisant des co-implantations d'ions hydrogène et hélium aux doses indiquées ci-dessus.

De préférence, on réalise une implantation assez profonde dans le matériau, pour ajouter la raideur de la couche à celle de l'oxyde créé pour favoriser le clivage.

Pour obtenir un clivage à une température inférieure à 250°C on peut avantageusement implanter le matériau 1, comme décrit ci-dessus, et le pré-fragiliser en lui faisant subir un recuit préliminaire. Ce recuit conduit à la création d'une zone fragile mais le clivage n'est pas amorcé.

On effectue ensuite le collage entre la surface traitée du PDMS 20 et la surface du semi-conducteur 1 ou de la couche 8 déposée sur cette surface puis l'amincissement du substrat 1, ici par fracture à l'aide d'un traitement thermique (assisté ou non d'un traitement mécanique). La couche mince obtenue peut ensuite être transférée sur un substrat final, la couche de PDMS étant éliminée par pelage.

## Revendications

1. Procédé de préparation du transfert d'une couche mince (5) à partir d'un substrat (1) initial, comportant les étapes suivantes :
a) traitement sous rayonnement ultra-violet d'une face d'une couche de polymère de type silicone, pour transformer en une couche d'oxyde la surface de ce polymère,
b) assemblage par collage direct de ce substrat (1) initial avec ladite face (25) de couche (20) de polymère,
c) amincissement du substrat (1) initial, pour former là couche mince (5) sur la couche (20) de polymère de type silicone.

2. Procédé selon la revendication 1, l'amincissement du substrat (1) initial étant réalisé par polissage mécanique et/ou chimique.

3. Procédé selon la revendication 1, comportant, avant l'étape a), la création, dans le substrat initial, d'une zone fragile enterrée (4), par implantation d'espéces ioniques et/ou atomiques (3), délimitant, dans ce substrat la couche mince (5) à transférer, l'amincissement du substrat (1) initial étant réalisé par application d'un traitement thermique et/ou mécanique de fracture du substrat initial, le long de la zone fragile enterrée.

4. Procédé selon la revendication précédente, le traitement de fracture étant réalisé par effet thermique, à une température inférieure à la température de décomposition du silicone.

5. Procédé selon l'une des revendications 3 ou 4, comportant, avant l'étape b), un recuit préliminaire de fragilisation.

6. Procédé de transfert d'une couche mince, comportant un procédé de préparation selon l'une des revendications 1 à 5, comportant en outre une étape de transfert de la couche mince formée lors de l'étape c), sur un substrat (30), dit de transfert.

7. Procédé selon la revendication 6, le substrat (30), dit de transfert, étant en matériau silicone.

8. Procédé selon l'une des revendications 6 ou 7, comportant en outre, après l'étape de transfert sur le substrat (30) de transfert, une étape de pelage de la couche (20) de polymère de type silicone.

9. Procédé selon la revendication 8, le pelage induisant ou comportant une séparation à l'interface du silicone et du silicone transformé en oxyde ou une séparation dans la couche de silicone.

10. Procédé selon la revendication 9, comportant en outre une étape d'élimination chimique de silicone résiduel.

11. Procédé selon l'une des revendications 9 ou 10, comportant en outre une étape supplémentaire d'élimination de la partie de silicone transformé en oxyde.

12. Procédé selon l'une des revendications 1 à 11, le polymère étant de type polydiméthylsiloxane (PDMS).

13. Procédé selon l'une des revendications 1 à 12, le traitement sous rayonnement ultra-violet ayant été réalisé sous atmosphère d'ozone.

14. Procédé selon l'une des revendications précédentes, comportant un traitement mécanique pour assister la séparation, d'une part, du film mince collé sur le silicone, et, d'autre part, du substrat initial restant.

15. Procédé selon l'une des revendications 1 à 14, comportant, préalablement à l'étape a), une étape de dépôt d'une couche d'oxyde ou d'une couche de nitrure sur le substrat (1) initial.

## Claims

1. Preparation method for transferring a thin layer (5) from an initial substrate (2), comprising the following steps:
a) treatment under ultraviolet radiation of one face of a silicone type polymer layer, to transform the surface of this polymer into an oxide layer,
b) assembly by direct bonding of this initial substrate (1) with said face (25) of the polymer layer (20),
c) thinning of the initial substrate (1), to form the thin layer (5) on the silicone type polymer layer (20).

2. Method according to claim 1, thinning of the initial substrate (1) being done by mechanical and/or chemical polishing.

3. Method according to claim 1, comprising the creation of a buried fragile zone (4) in the initial substrate before the step a), by implantation of ionic and/or atomic species (3), delimiting the thin layer (5) to be transferred in this substrate, thinning of the initial substrate (1) being done by applying a heat and/or mecha.nical fracture treatment of the initial substrate along the buried fragile zone.

4. Method according to the previous claim, the fracture treatment being done by thermal effect, at a temperature below the silicone decomposition temperature.

5. Method according to one of claims 3 or 4, comprising a weakening preliminary annealing, before step b.

6. Method for transferring a thin layer, comprising a preparation method according to one of claims 1 to 5, also comprising a step for transferring the thin layer formed during step c), onto a said transfer substrate (30).

7. Method according to claim 6, the said transfer substrate (30) being made from a silicone material.

8. Method according to one of claims 6 or 7, also comprising a step for peeling the silicone type polymer layer (20) after the transfer step onto the transfer substrate (30).

9. Method according to claim 8, the peeling inducing a separation at the interface between the silicone and the silicone transformed into oxide or a separation in the silicone layer.

10. Method according to claim 9, also comprising a step to chemically eliminate the residual silicone.

11. method according to one of claims 9 or 10, also comprising an additional step to eliminate the part of the silicone transformed into oxide.

12. Method according to one of claims 1 to 11, the polymer being of polydimethylsiloxane (PDMS) type.

13. Method according to one of claims 1 to 12, the treatment under ultraviolet radiation being done under ozone atmosphere.

14. Method according to one of the previous claims, comprising a mechanical treatment to participate firstly in the separation of the thin film bonded to the silicone, and secondly the remaining initial substrate.

15. Method according to one of claims 1 to 14, comprising a step to deposit an oxide layer or a nitride layer on the initial substrate (1) before step a).

## Patentansprüche

1. Verfahren zur Vorbereitung der Überführung bzw. Übertragung einer dünnen Schicht (5) ausgehend von einem anfänglichen bzw. Ausgangssubstrat (1), das Verfahren umfassend die folgenden Verfahrensstufen bzw. -Schritte:
a) Behandeln einer Seite bzw. Oberfläche einer Schicht aus einem Polymer vom Silikontyp mit UV-Strahlung, zur Umwandlung der Oberfläche dieses Polymers in eine Oxydschicht,
b) Montage bzw. Einbau dieses anfänglichen bzw. Ausgangssubstrats (1) auf der genannten Oberfläche (25) der Polymerschicht (20),
c) Dickenverringerung des anfänglichen bzw. Ausgangssubstrats (1) zur Bildung der dünnen Schicht (5) auf der Schicht (20) aus dem Polymer vom Silikontyp.

2. Verfahren nach Anspruch 1, bei welchem die Dickenverringerung des anfänglichen bzw. Ausgangssubstrats (1) mittels mechanischer und/oder chemischer Poliger- bzw. Schleifbehandlung erfolgt.

3. Verfahren nach Anspruch 1, welches vor dem Verfahrensschritt a) in dem anfänglichen bzw. Ausgangssubstrat die Schaffung einer vergrabenen bzw. tiefliegenden fragilen Zone (4) mittels Implantation von lonen- und/oder Atomspezies (3) umfasst, wobei diese Zone in dem Substrat die zu überführende bzw. zu übertragende dünne Schicht (5) begrenzt und wobei die Dickenverringerung des anfänglichen bzw. Ausgangssubstrats (1) mittels Anwendung einer thermischen und/oder mechanischen Bruchbehandlung des anfänglichen Substrats entlang der vergrabenen bzw. tiefliegenden fragilen Zone erfolgt.

4. Verfahren nach dem vorhergehenden Anspruch, bei welchem die Bruchbehandlung mittels Wärmeeinwirkung bei einer Temperatur unterhalb der Zersetzungstemperatur des Silikons erfolgt.

5. Verfahren nach einem der Ansprüche 3 oder 4, welches vor der Verfahrensstufe b) eine Glühbehandlund zur vorläufigen Fragilisierung umfasst.

6. Verfahren zur Überführung bzw. Übertragung einer dünnen Schicht, welches ein Vorbereitungsverfahren nach einem der Ansprüche 1 bis 5 umfasst, wobei das Verfahren des weiteren eine Verfahrensstufe zur Überführung bzw. Übertragung der in der Verfahrensstufe c) gebildeten dünnen Schicht auf ein sogenanntes Überführungs- bzw. Übertragungssubstrat (30) umfasst.

7. Verfahren nach Anspruch 6, bei welchem das sogenannte Überführungssubstrat (30) aus einem Silikonmaterial besteht.

8. Verfahren nach einem der Ansprüche 6 oder 7, welches des weiteren nach der Verfahrensstufe der Überführung auf das Überführungssubstrat (30) eine Verfahrensstufe des Abschälens der Schicht (20) aus dem Silikonpolymer umfasst.

9. Verfahren nach Anspruch 8, bei welchem das Abschälen eine Trennung an der Grenzfläche des Silikons und des in Oxyd umgewandelten Silikons oder eine Trennung in der Silikonschicht einleitet oder umfasst.

10. Verfahren nach Anspruch 9, welches des weiteren eine Verfahrensstufe der chemischen Eliminierung des restlichen Silikons umfasst.

11. Verfahren nach einem der Ansprüche 9 oder 10, welches des weiteren eine zusätzliche Verfahrensstufe zur Eliminierung des in Oxyd umgewandelten Teils des Silikons umfasst.

12. Verfahren nach einem der Ansprüche 1 bis 11, bei welchem das Polymer vom Typ Polydimethylsiloxan (PDMS) ist.

13. Verfahren nach einem der Ansprüche 1 bis 12, bei welchem die Behandlung mit UV-Strahlung in Ozonatmosphäre vorgenommen wurde.

14. Verfahren nach einem der vorhergehenden Ansprüche, das eine mechanische Behandlung umfasst, welche die Trennung einerseits des auf dem Silikon verklebten dünnen Films und andererseits des verbliebenen anfänglichen bzw. Ausgangssubstrats unterstützt.

15. Verfahren nach einem der Ansprüche 1 bis 14, welches vorgängig zu der Verfahrensstufe a) eine Verfahrensstufe der Abscheidung einer Oxydschicht oder einer Nitridschicht auf dem anfänglichen oder Ausgangssubstrat (1) umfasst.
